# EUROPEAN PATENT SPECIFICATION

(11) **EP 3 919 226 B1**
(45) Date of publication and mention of the grant of the patent: **13.08.2025**
(21) Application number: 20748992.3
(22) Date of filing: 15.01.2020
(51) Int. Cl.: B24B 1/00, C09J 5/06, H01L 21/304, H01L 21/683, C09J 5/00

(54) **METHOD FOR MANUFACTURING ELECTRONIC COMPONENT**
VERFAHREN ZUR HERSTELLUNG EINER ELEKTRONISCHEN KOMPONENTE
PROCÉDÉ DE FABRICATION DE COMPOSANT ÉLECTRONIQUE

(30) Priority: 30.01.2019 JP 2019013988
(43) Date of publication of application: 08.12.2021
(73) Proprietor: Nitto Denko Corporation, Ibaraki-shi, Osaka 567-8680 (JP)
(72) Inventor: UENO Shusaku, Ibaraki-shi, Osaka 567-8680 (JP); HIRAYAMA Takamasa, Ibaraki-shi, Osaka 567-8680 (JP); AKAI Makoto, Ibaraki-shi, Osaka 567-8680 (JP)
(74) Representative: Müller-Boré & Partner Patentanwälte PartG mbB
(86) International application number: PCT/JP2020/000995
(87) International publication number: WO 2020/158381

(56) References cited:
- JP-A- 2004 300 231
- JP-A- 2004 300 231
- JP-A- 2013 203 800
- JP-A- 2013 203 800
- US-A1- 2014 044 957

## Description

### Technical Field

The present invention relates to a method of manufacturing an electronic part.

### Background Art

Hitherto, a manufacturing process of an electronic part has involved fixation of a substrate onto a support during processing of the substrate, and a wax has often been used as a fixing material. After completion of predetermined processing, the wax is melted by heating to separate the substrate serving as a workpiece from the support.

In recent years, as the substrate, a substrate that is hard and brittle (hard and brittle substrate), such as a sapphire wafer, has been used in some cases. However, when such substrate is fixed with the wax as described above, a defect, such as breakage of the hard and brittle substrate, is liable to occur at the time of the separation after the processing. This is conceivably because the wax melted by heating is highly viscous, leading to application of excessive loading to the substrate along with movement during the separation of the substrate (e.g., sliding of the substrate in a horizontal direction or picking-up of the substrate in a vertical direction) . Such problem becomes remarkable particularly after such processing as thinning of the hard and brittle substrate by grinding/polishing.

From US 2014/044957 A1 there is known a method of manufacturing an electronic part, which includes processing a workpiece fixed onto a support, the method comprising, fixing the workpiece by arranging at least one heat-peelable layer between the support and the workpiece, processing a surface of the fixed workpiece on an opposite side to the heat-peelable layer and separating the workpiece from the support by heating the heat-peelable layer after the processing.

### Citation List

### Patent Literature

[PTL 1] JP 2011-151163 A

### Summary of Invention

### Technical Problem

The present invention has been made in order to solve the problem of the related art described above, and an object of the present invention is to provide a method of manufacturing an electronic part including fixing a workpiece to a support and separating the workpiece from the support, the method being capable of preventing the workpiece from being damaged during the separation of the workpiece from the support.

### Solution to Problem

According to one embodiment of the present invention, there is provided a method of manufacturing an electronic part as defined in claim 1.

In one embodiment, the fixing the workpiece includes arranging the pressure-sensitive adhesive tape between the heat-peelable layer and the workpiece.

In one embodiment, the pressure-sensitive adhesive tape is in a state of being bonded to the workpiece during the separating the workpiece.

In one embodiment, the bonding of the laminate A and the laminate B is performed by thermocompression bonding at from 80°C to 150°C.

In one embodiment, a heating temperature in the separating the workpiece from the support is from 90°C to 300°C.

In one embodiment, the heat-peelable layer contains thermally expandable microspheres.

### Advantageous Effects of Invention

According to the present invention, the method of manufacturing an electronic part including fixing a workpiece to a support and separating the workpiece from the support, the method being capable of preventing the workpiece from being damaged during the separation of the workpiece from the support, can be provided.

### Brief Description of Drawings

FIGS. 1 are schematic views for illustrating a method of manufacturing an electronic part according to one embodiment of the present invention.
FIGS. 2 are schematic views for illustrating a method of manufacturing an electronic part according to one embodiment of the present invention.
FIG. 3 is a schematic view for illustrating a method of manufacturing an electronic part according to another embodiment of the present invention.
FIG. 4 is a schematic view for illustrating a method of manufacturing an electronic part according to another embodiment of the present invention.
FIG. 5 is a schematic view for illustrating a method of manufacturing an electronic part according to another embodiment of the present invention.

### Description of Embodiments

### A. Outline of Method of Manufacturing Electronic Part

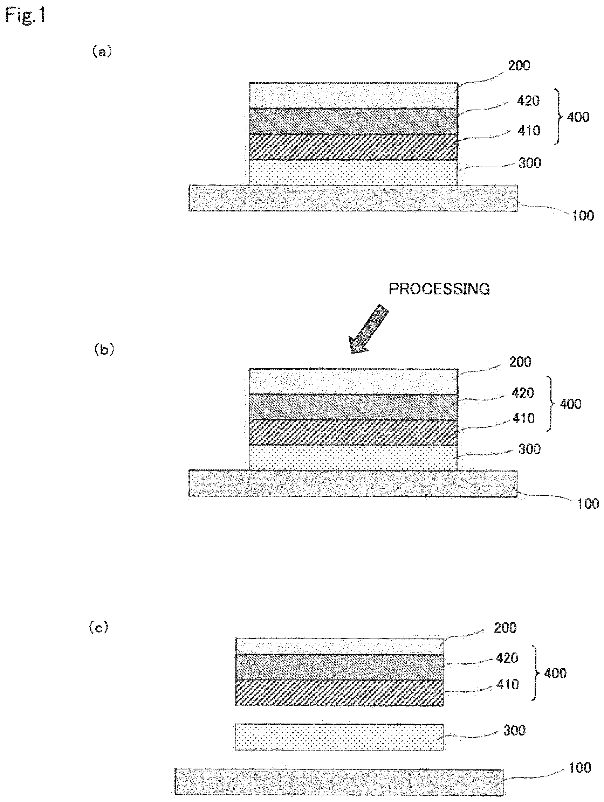

FIGS. **1** are schematic views for illustrating a method of manufacturing an electronic part according to one embodiment of the present invention. The method of manufacturing an electronic part of the present invention includes processing a workpiece **200** fixed onto a support **100.** In the method of manufacturing an electronic part of the present invention, the workpiece **200** is fixed by arranging at least one heat-peelable layer **300** between the support **100** and the workpiece **200** (FIG. **1(a)**). After the workpiece **200** has been thus fixed, the surface of the workpiece **200** on the opposite side to the heat-peelable layer **300** is processed (FIG. **1(b)****).** After the workpiece has been thus processed, the workpiece **200** is separated from the support **100** by heating the heat-peelable layer **300** (FIG. **1(c)**).

Any appropriate workpiece may be used as the workpiece in the manufacturing method. As the workpiece, for example, a hard and brittle substrate, such as a sapphire wafer, a silicon carbide wafer, a gallium nitride wafer, a gallium oxide wafer, a diamond wafer, a silicon nitride wafer, an alumina nitride wafer, a quartz wafer, a gallium arsenide wafer, an indium phosphide wafer, or a silicon wafer, may be adopted. The manufacturing method of the present invention is particularly useful for processing of a workpiece that may be damaged even by slight loading. The support is not particularly limited, and for example, a ceramic board is used.

The term "heat-peelable layer" means a layer that has a pressure-sensitive adhesive property at or below a predetermined temperature, and that loses its pressure-sensitive adhesive property when heated. For example, when the heat-peelable layer is heated, its pressure-sensitive adhesive strength for the support is reduced to 0.2 N/20 mm or less (preferably 0.1 N/20 mm or less). The pressure-sensitive adhesive strength is measured by a method in conformity with JIS Z 0237:2000. A heating temperature in the separation of the workpiece is set to a temperature at which the heat-peelable layer loses its pressure-sensitive adhesive property. The heating temperature is preferably from 90°C to 300°C, more preferably from 100°C to 280°C. The heat-peelable layer loses its pressure-sensitive adhesive property on at least one surface thereof. In one embodiment, as illustrated in FIG. **1(c)****,** the heat-peelable layer **300** loses its pressure-sensitive adhesive property on each of its upper and lower surfaces (i.e., support-side surface and workpiece-side surface). Details of the heat-peelable layer are described later.

As described above, the workpiece is subjected to predetermined processing after being fixed to the support. Examples of the processing include: backgrinding involving grinding/polishing the back surface of the workpiece (surface thereof on the opposite side to the heat-peelable layer); dicing involving singulating the workpiece into small pieces; vapor deposition, sputtering, or plating treatment on the surface of the workpiece; formation of a pattern on the surface of the workpiece; coating of the surface of the workpiece; and encapsulation of the workpiece in a resin. The processing of the workpiece may be performed on not only the surface thereof on the opposite side to the heat-peelable layer, but also the side surface of the workpiece.

In the present invention, the workpiece is fixed onto the support via the heat-peelable layer, and thus the workpiece can be satisfactorily fixed during the processing of the workpiece. Meanwhile, during the separation of the workpiece from the support after the processing, the workpiece can be separated without application of unneeded loading thereto, and hence the workpiece can be prevented from being damaged. In addition, the step of separating the workpiece can be simplified. The present invention exhibiting such effect is useful for processing of a hard and brittle substrate, such as a sapphire wafer, and is particularly useful for, for example, processing (backgrinding) involving thinning the hard and brittle substrate and processing of the thinned hard and brittle substrate.

In one embodiment, as illustrated in FIGS. **1****,** the fixation of the workpiece **200** involves arranging a pressure-sensitive adhesive tape **400** between the support **100** and the workpiece **200.** The pressure-sensitive adhesive tape **400** typically includes a base material **410** and a pressure-sensitive adhesive layer **420** arranged on at least one side of the base material **410.**

In one embodiment, as illustrated in FIGS. **1****,** the fixation of the workpiece **200** involves arranging the pressure-sensitive adhesive tape **400** between the heat-peelable layer **300** and the workpiece **200.** The pressure-sensitive adhesive tape **400** is preferably arranged so that the pressure-sensitive adhesive layer **420** may be on the workpiece **200** side. When the pressure-sensitive adhesive tape **400** is thus arranged, a state in which the pressure-sensitive adhesive tape **400** is bonded to the workpiece **200** may be achieved after the separation of the workpiece **200** from the support **100.** With this configuration, the pressure-sensitive adhesive tape **400** can function as a protective film for the adherend **200,** and can prevent the adherend **200** from being damaged in a process after the separation of the workpiece **200.** When the heat-peelable layer **300** is arranged and the pressure-sensitive adhesive tape is used as described above, damage risks in all situations, such as peeling of the workpiece and handling (e.g., conveyance or transfer), can be reduced. The present invention exhibiting such effect is useful for processing of a hard and brittle substrate, such as a sapphire wafer, and is particularly useful for, for example, processing (backgrinding) involving thinning the hard and brittle substrate and processing of the thinned hard and brittle substrate. The heat-peelable layer may be separated from the support in a state of being bonded to the pressure-sensitive adhesive tape, or may be separated from the pressure-sensitive adhesive tape. In addition, the heat-peelable layer may be separated from both of the support and the pressure-sensitive adhesive tape.

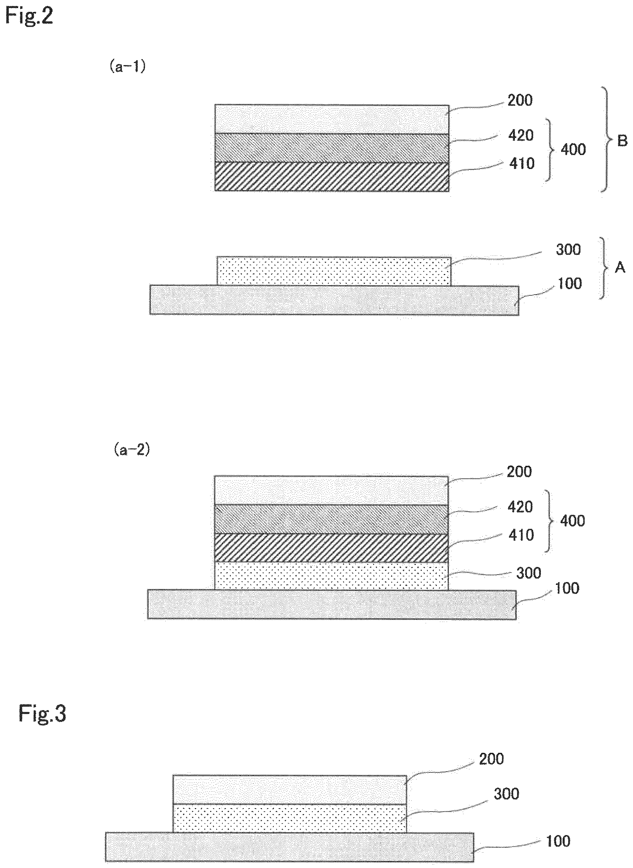

FIGS. **2** are schematic views for illustrating a method of manufacturing an electronic part according to one embodiment of the present invention. This manufacturing method includes forming a laminate A including the support **100** and the heat-peelable layer **300,** forming a laminate B including the workpiece **200** and the pressure-sensitive adhesive tape **400** (FIG. **2****(a-1)**), and bonding the heat-peelable layer **300** of the laminate A and the pressure-sensitive adhesive tape **400** of the laminate B to each other, to thereby fix the workpiece **200** (FIG. **2****(a-2)**). It is preferred that: the pressure-sensitive adhesive tape **400** be arranged so that the base material **410** may be on the heat-peelable layer **300** side; and at the time of the bonding of the laminate A and the laminate B to each other, the heat-peelable layer **300** of the laminate A and the base material **410** of the laminate B be opposed to each other. After the workpiece has been fixed as described above, there may be performed: processing of the surface of the fixed workpiece on the opposite side to the heat-peelable layer; and separation of the workpiece from the support by heating the heat-peelable layer after the processing. According to the manufacturing method of this embodiment, the workpiece is prevented from being damaged before the processing of the workpiece, and besides, as described above, damage risks in all situations, such as peeling of the workpiece and handling (e.g., conveyance or transfer), can be reduced.

In one embodiment, the laminate A and the laminate B are bonded to each other by thermocompression bonding. The temperature of the thermocompression bonding is, for example, from 80°C to 150°C, preferably from 80°C to 130°C. The temperature of the thermocompression bonding is preferably lower than the temperature at which the heat-peelable layer loses its pressure-sensitive adhesive property. A difference between the temperature of the thermocompression bonding and the temperature at which the heat-peelable layer loses its pressure-sensitive adhesive property is, for example, from 10°C to 70°C, preferably from 20°C to 60°C.

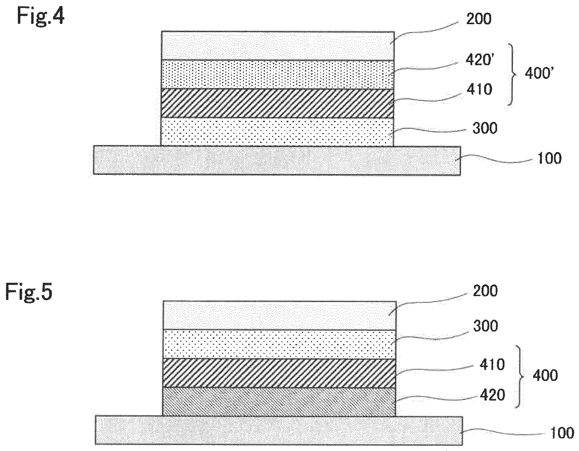

FIG. **3** to FIG. **5** are each a schematic view for illustrating a method of manufacturing an electronic part according to another embodiment of the present invention. In each of FIG. **3** to FIG. **5****,** a state in which the workpiece **200** is fixed onto the support **100** is illustrated. In the manufacturing method illustrated in FIG. **3****,** only the heat-peelable layer **300** is arranged between the support **100** and the workpiece **200.** In the manufacturing method illustrated in FIG. **4****,** a pressure-sensitive adhesive tape **400'** includes a heat-peelable pressure-sensitive adhesive layer **420'.** Like the heat-peelable layer, the heat-peelable pressure-sensitive adhesive layer **420'** is a layer that loses its pressure-sensitive adhesive property when heated. In the manufacturing method illustrated in FIG. **5****,** the pressure-sensitive adhesive tape **400** is arranged between the support **100** and the heat-peelable layer **300.** The pressure-sensitive adhesive tape **400** is preferably arranged so that the pressure-sensitive adhesive layer **420** may be on the support **100** side. Also in the manufacturing method illustrated in FIG. **5****,** the pressure-sensitive adhesive layer may be a heat-peelable pressure-sensitive adhesive layer. After the workpiece has been fixed as described above, there may be performed: processing of the surface of the fixed workpiece on the opposite side to the heat-peelable layer; and separation of the workpiece from the support by heating the heat-peelable layer after the processing. In each of the embodiments illustrated in FIG. **3** to FIG. **5****,** the heat-peelable layer may express peelability on one surface thereof, or may express peelability on both surfaces thereof.

The heat-peelable layer may selectively express peelability on one surface or both surfaces thereof through utilization of a temperature gradient generated by a method for its heating. For example, when a heater heating method is selected, peelability is generated only on the support side when heating is performed from the support side, or only on the workpiece side when heating is performed from the workpiece side. Meanwhile, when an oven heating method is selected, heat is uniformly applied to the heat-peelable layer, and hence peelability is generated on both surfaces thereof facing the support and the workpiece.

### B. Heat peelable Layer

The heat-peelable layer contains a pressure-sensitive adhesive for imparting a pressure-sensitive adhesive property, and a foaming agent for imparting peelability.

The shear adhesive strength of the heat-peelable layer for SUS304BA at 25°C is preferably from 100 N/cm² to 800 N/cm², more preferably from 200 N/cm² to 700 N/cm². Herein, the shear adhesive strength may be measured by: bonding and fixing the peelable layer to SUS304BA; thermocompression-bonding another SUS304BA plate so as to sandwich the peelable layer under the bonding conditions of 80°C and 0.3 MPa for 1 minute; applying an external force at a tensile rate of 50 mm/min in a horizontal direction to the SUS304BA plates; and reading the maximum breaking load from the thus obtained load-displacement curve.

The thickness of the heat-peelable layer is preferably from 1 µm to 300 µm, more preferably from 1 µm to 250 µm, still more preferably from 1 µm to 100 um, particularly preferably from 1 µm to 50 µm.

### B-1. Pressure-sensitive Adhesive

Any appropriate pressure-sensitive adhesive may be used as the pressure-sensitive adhesive for forming the heat-peelable layer as long as the effects of the present invention are obtained. Examples of the pressure-sensitive adhesive include pressure-sensitive adhesives each containing, as a base polymer (pressure-sensitive adhesive resin), a thermoplastic elastomer, an acrylic resin, a silicone-based resin, a vinyl alkyl ether-based resin, a polyester-based resin, a polyamide-based resin, a urethane-based resin, a fluorinated resin, or the like.

Examples of the styrene-based elastomer include a styrene-butadiene copolymer (SB), a styrene-isoprene copolymer (SI), a styrene-isoprene-styrene block copolymer (SIS), a styrene-butadiene-styrene block copolymer (SBS), a styrene-isobutylene-styrene copolymer (SIBS), a styrene-ethylenebutylene-styrene block copolymer (SEBS), a styrene-ethylene-propylene block copolymer (SEP), a styrene-ethylene-propylene-styrene block copolymer (SEPS), and modified products thereof. Of those, SEBS, SBS, SIS, and SIBS are preferred. Those copolymers are each preferably a block copolymer. In one embodiment, an acid-modified styrene-based elastomer (preferably acid-modified SEBS, SBS, SIS, or SIBS) is used as the styrene-based elastomer.

The content ratio of a constituent unit derived from styrene in the styrene-based elastomer is preferably from 10 parts by weight to 75 parts by weight, more preferably from 20 parts by weight to 70 parts by weight, still more preferably from 20 parts by weight to 50 parts by weight with respect to 100 parts by weight of the styrene-based elastomer.

As the acrylic resin, for example, an acrylic resin containing one kind or two or more kinds of (meth)acrylic acid alkyl esters as a monomer component is used. Specific examples of the (meth)acrylic acid alkyl ester include (meth)acrylic acid C1-20 alkyl esters, such as methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth) acrylate, nonadecyl (meth)acrylate, and eicosyl (meth)acrylate. Of those, a (meth)acrylic acid alkyl ester having a linear or branched alkyl group having 4 to 18 carbon atoms may be preferably used.

The acrylic polymer may contain a unit corresponding to any other monomer component copolymerizable with the (meth)acrylic acid alkyl ester, as required, for the purpose of modification of cohesive strength, heat resistance, cross-linkability, or the like. Examples of such monomer component include: carboxyl group-containing monomers, such as acrylic acid, methacrylic acid, carboxyethyl acrylate, carboxypentyl acrylate, itaconic acid, maleic acid, fumaric acid, and crotonic acid; acid anhydride monomers, such as maleic anhydride and itaconic anhydride; hydroxyl group-containing monomers, such as hydroxyethyl (meth) acrylate, hydroxypropyl (meth)acrylate, hydroxybutyl (meth)acrylate, hydroxyhexyl (meth)acrylate, hydroxyoctyl (meth)acrylate, hydroxydecyl (meth)acrylate, hydroxylauryl (meth) acrylate, and (4-hydroxymethylcyclohexyl)methyl methacrylate; sulfonic acid group-containing monomers, such as styrenesulfonic acid, allylsulfonic acid, 2-(meth)acrylamido-2-methylpropanesulfonic acid, (meth)acrylamidopropanesulfonic acid, sulfopropyl (meth)acrylate, and (meth)acryloyloxynaphthalenesulfonic acid; (N-substituted) amide-based monomers, such as (meth)acrylamide, N,N-dimethyl(meth)acrylamide, N-butyl(meth)acrylamide, N-methylol (meth)acrylamide, and N-methylolpropane (meth)acrylamide; aminoalkyl (meth)acrylate-based monomers, such as aminoethyl (meth)acrylate, N,N-dimethylaminoethyl (meth)acrylate, and t-butylaminoethyl (meth)acrylate; alkoxyalkyl (meth)acrylate-based monomers, such as methoxyethyl (meth)acrylate and ethoxyethyl (meth)acrylate; maleimide-based monomers, such as N-cyclohexylmaleimide, N-isopropylmaleimide, N-laurylmaleimide, and N-phenylmaleimide; itaconimide-based monomers, such as N-methyl itaconimide, N-ethyl itaconimide, N-butyl itaconimide, N-octyl itaconimide, N-2-ethylhexyl itaconimide, N-cyclohexyl itaconimide, and N-lauryl itaconimide; succinimide-based monomers, such as N-(meth)acryloyloxymethylene succinimide, N-(meth)acryloyl-6-oxyhexamethylene succinimide, and N-(meth)acryloyl-8-oxyoctamethylene succinimide; vinyl-based monomers, such as vinyl acetate, vinyl propionate, N-vinylpyrrolidone, methylvinylpyrrolidone, vinylpyridine, vinylpiperidone, vinylpyrimidine, vinylpiperazine, vinylpyrazine, vinylpyrrole, vinylimidazole, vinyloxazole, vinylmorpholine, N-vinylcarboxylic acid amides, styrene, α-methylstyrene, and N-vinylcaprolactam; cyanoacrylate monomers, such as acrylonitrile and methacrylonitrile; epoxy group-containing acrylic monomers, such as glycidyl (meth)acrylate; glycol-based acrylic ester monomers, such as polyethylene glycol (meth)acrylate, polypropylene glycol (meth)acrylate, methoxyethylene glycol (meth)acrylate, and methoxypolypropylene glycol (meth)acrylate; acrylic ester-based monomers each having, for example, a heterocycle, a halogen atom, or a silicon atom, such as tetrahydrofurfuryl (meth)acrylate, fluorine (meth)acrylate, and silicone (meth)acrylate; polyfunctional monomers, such as hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy acrylate, polyester acrylate, and urethane acrylate; olefin-based monomers, such as isoprene, butadiene, and isobutylene; and vinyl ether-based monomers, such as vinyl ether. Those monomer components may be used alone or in combination thereof.

The pressure-sensitive adhesive may contain any appropriate additive as required. Examples of the additive include a tackifying resin, a plasticizer, a pigment, a dye, a filler, an age resistor, a conductive material, an antistatic agent, a UV absorber, a light stabilizer, a peeling modifier, a softener, a surfactant, a flame retardant, an antioxidant, and a cross-linking agent.

In one embodiment, the pressure-sensitive adhesive contains a tackifying resin. Particularly when the pressure-sensitive adhesive contains the styrene-based elastomer, it is preferred to use the elastomer and the tackifying resin in combination. When the tackifying resin is used in combination, a heat-peelable layer excellent in pressure-sensitive adhesive property can be formed. Any appropriate tackifying resin is used as the tackifying resin as long as the effects of the present invention are obtained. Specific examples of the tackifying resin include a rosin-based tackifying resin (such as unmodified rosin, modified rosin, a rosin phenol-based resin, or a rosin ester-based resin), a terpene-based tackifying resin (such as a terpene-based resin, a terpene phenol-based resin, a styrene-modified terpene-based resin, an aromatic modified terpene-based resin, or a hydrogenated terpene-based resin), a hydrocarbon-based tackifying resin (such as an aliphatic hydrocarbon resin, an aliphatic cyclic hydrocarbon resin, an alicyclic hydrocarbon resin (e.g., a styrene-based resin or a xylene-based resin), an aliphatic/aromatic petroleum resin, an aliphatic/alicyclic petroleum resin, a hydrogenated hydrocarbon resin, a coumarone-based resin, or a coumarone indene-based resin), a phenol-based tackifying resin (such as an alkylphenol-based resin, a xylene formaldehyde-based resin, resol, or novolac), a ketone-based tackifying resin, a polyamide-based tackifying resin, an epoxy-based tackifying resin, and an elastomer-based tackifying resin. Of those, a terpene-based tackifying resin, a rosin-based tackifying resin, or a hydrocarbon-based tackifying resin (preferably an alicyclic saturated hydrocarbon resin) is preferred. The tackifying resins may be used alone or in combination. The content of the tackifying resin is preferably from 0 parts by weight to 350 parts by weight, more preferably from 1 part by weight to 350 parts by weight, still more preferably from 1 part by weight to 300 parts by weight, particularly preferably from 20 parts by weight to 250 parts by weight with respect to 100 parts by weight of the base polymer. When the content falls within such ranges, a heat-peelable layer excellent in pressure-sensitive adhesive property can be formed. When the content of the tackifying resin is excessively high, the heat-peelable layer may become brittle.

In one embodiment, the pressure-sensitive adhesive contains a surfactant. When the pressure-sensitive adhesive containing the surfactant is used, a light-peel layer is formed in the heat-peelable layer through segregation of the surfactant by heating, and hence a pressure-sensitive adhesive sheet excellent in peelability can be obtained. Any appropriate surfactant may be used as the surfactant as long as the effects of the present invention are obtained. Examples of the surfactant include a nonionic surfactant, an anionic surfactant, a cationic surfactant, and a zwitterionic surfactant. Of those, a nonionic surfactant, an anionic surfactant, or a cationic surfactant is preferably used, and a nonionic surfactant or a cationic surfactant is more preferably used. The surfactants may be used alone or in combination thereof. The content of the surfactant is preferably from 0.001 part by weight to 15 parts by weight, more preferably from 0.01 part by weight to 10 parts by weight, still more preferably from 0.1 part by weight to 8 parts by weight, particularly preferably from 1 part by weight to 5 parts by weight with respect to 100 parts by weight of the base polymer.

In one embodiment, the pressure-sensitive adhesive contains a cross-linking agent. Any appropriate cross-linking agent may be used as the cross-linking agent as long as the effects of the present invention are obtained. Examples of the cross-linking agent include an epoxy-based cross-linking agent, an isocyanate-based cross-linking agent, a melamine-based cross-linking agent, a peroxide-based cross-linking agent, a urea-based cross-linking agent, a metal alkoxide-based cross-linking agent, a metal chelate-based cross-linking agent, a metal salt-based cross-linking agent, a carbodiimide-based cross-linking agent, an oxazoline-based cross-linking agent, an aziridine-based cross-linking agent, and an amine-based cross-linking agent. Of those, an epoxy-based cross-linking agent is preferred. Examples of the epoxy-based cross-linking agent include N,N,N',N'-tetraglycidyl-m-xylenediamine, diglycidylaniline, 1,3-bis(N,N-glycidylaminomethyl)cyclohexane (manufactured by Mitsubishi Gas Chemical Company, Inc., product name: "TETRAD-C"), 1,6-hexanediol diglycidyl ether (manufactured by Kyoeisha Chemical Co., Ltd., product name: "Epolite 1600"), neopentyl glycol diglycidyl ether (manufactured by Kyoeisha Chemical Co., Ltd., product name: "Epolite 1500NP"), ethylene glycol diglycidyl ether (manufactured by Kyoeisha Chemical Co., Ltd., product name: "Epolite 40E"), propylene glycol diglycidyl ether (manufactured by Kyoeisha Chemical Co., Ltd., product name: "Epolite 70P"), polyethylene glycol diglycidyl ether (manufactured by NOF Corporation, product name: "EPIOL E-400"), polypropylene glycol diglycidyl ether (manufactured by NOF Corporation, product name: "EPIOL P-200"), sorbitol polyglycidyl ether (manufactured by Nagase ChemteX Corporation, product name: "Denacol EX-611"), glycerol polyglycidyl ether (manufactured by Nagase ChemteX Corporation, product name: "Denacol EX-314"), pentaerythritol polyglycidyl ether, polyglycerol polyglycidyl ether (manufactured by Nagase ChemteX Corporation, product name: "Denacol EX-512"), sorbitan polyglycidyl ether, trimethylolpropane polyglycidyl ether, adipic acid diglycidyl ester, o-phthalic acid diglycidyl ester, triglycidyl-tris(2-hydroxyethyl) isocyanurate, resorcin diglycidyl ether, bisphenol-S-diglycidyl ether, and an epoxy-based resin having two or more epoxy groups in a molecule thereof. The content of the epoxy-based cross-linking agent is typically from 0.01 part by weight to 10 parts by weight, preferably from 0.03 part by weight to 5 parts by weight with respect to 100 parts by weight of the base polymer.

### B-2. Foaming Agent

The foaming agent is an additive that can foam through heating. Any appropriate foaming agent is used as the foaming agent as long as the effects of the present invention are obtained. Thermally expandable microspheres may be typically used as the foaming agent. When a heat-peelable layer containing the thermally expandable microspheres is heated, the thermally expandable microspheres expand or foam to cause unevenness on its pressure-sensitive adhesive surface, with the result that its pressure-sensitive adhesive strength is decreased or lost.

The foaming starting temperature of the foaming agent is preferably from 90°C to 300°C, more preferably from 90°C to 280°C, still more preferably from 100°C to 260°C. Herein, the foaming starting temperature corresponds to, for example, the lowest temperature at which the pressure-sensitive adhesive strength of the heat-peelable layer becomes 10% or less with respect to the ordinary-state pressure-sensitive adhesive strength (pressure-sensitive adhesive strength for a PET film at 23°C) of the heat-peelable layer. The term "pressure-sensitive adhesive strength" as used in this case refers to a pressure-sensitive adhesive strength measured by a method in conformity with JIS Z 0237:2000 (bonding conditions: one pass back and forth with a 2 kg roller, peel rate: 300 mm/min, peel angle: 180°) . In addition, the pressure-sensitive adhesive strength at the foaming starting temperature (and of a measurement sample after heating) is measured after the measurement sample has been returned to ordinary temperature (23°C). When the foaming agent is thermally expandable microspheres, a temperature at which the thermally expandable microspheres start to expand corresponds to the foaming starting temperature.

Any appropriate thermally expandable microspheres may be used as the thermally expandable microspheres. For example, microspheres each obtained by encapsulating a substance which easily expands through heating in a shell having elasticity may be used as the thermally expandable microspheres. Such thermally expandable microspheres may be manufactured by any appropriate method, such as a coacervation method or an interfacial polymerization method.

Examples of the substance which easily expands through heating include: a low-boiling point liquid, such as propane, propylene, butene, n-butane, isobutane, isopentane, neopentane, n-pentane, n-hexane, isohexane, heptane, octane, petroleum ether, a halomethane, or a tetraalkylsilane; and azodicarbonamide, which is gasified by thermal decomposition.

A substance for forming the shell is, for example, a polymer formed of: a nitrile monomer, such as acrylonitrile, methacrylonitrile, α-chloroacrylonitrile, α-ethoxyacrylonitrile, or fumaronitrile; a carboxylic acid monomer, such as acrylic acid, methacrylic acid, itaconic acid, maleic acid, fumaric acid, or citraconic acid; vinylidene chloride; vinyl acetate; a (meth)acrylic acid ester, such as methyl (meth)acrylate, ethyl (meth)acrylate, n-butyl (meth)acrylate, isobutyl (meth)acrylate, t-butyl (meth)acrylate, isobornyl (meth)acrylate, cyclohexyl (meth)acrylate, benzyl (meth)acrylate, or β-carboxyethyl acrylate; a styrene monomer, such as styrene, α-methylstyrene, or chlorostyrene; or an amide monomer, such as acrylamide, a substituted acrylamide, methacrylamide, or a substituted methacrylamide. The polymer formed of such monomer may be a homopolymer, or may be a copolymer. Examples of the copolymer include a vinylidene chloride-methyl methacrylate-acrylonitrile copolymer, a methyl methacrylate-acrylonitrile-methacrylonitrile copolymer, a methyl methacrylate-acrylonitrile copolymer, and an acrylonitrile-methacrylonitrile-itaconic acid copolymer.

Commercially available thermally expandable microspheres may be used as the thermally expandable microspheres. Specific examples of the commercially available thermally expandable microspheres include: products manufactured under the product name "Matsumoto Microsphere" (grade: F-30, F-30D, F-36D, F-36LV, F-50, F-50D, F-65, F-65D, FN-100SS, FN-100SSD, FN-180SS, FN-180SSD, F-190D, F-260D, and F-2800D) by Matsumoto Yushi-Seiyaku Co., Ltd.; products manufactured under the product name "Expancel" (grade: 053-40, 031-40, 920-40, 909-80, and 930-120) by Japan Fillite Co., Ltd.; products manufactured under the product name "DAIFOAM" (grade: H750, H850, H1100, S2320D, S2640D, M330, M430, and M520) by Kureha Chemical Industry Co., Ltd.; and products manufactured under the product name "ADVANCELL" (grade: EML101, EMH204, EHM301, EHM302, EHM303, EM304, EHM401, EM403, and EM501) by Sekisui Chemical Co., Ltd.

Under an ambient temperature of 25°C, the average particle diameter of the thermally expandable microspheres before the foaming of the thermally expandable microspheres is preferably 50 µm or less, more preferably from 1 µm to 50 µm, still more preferably from 3 µm to 35 µm, particularly preferably from 5 µm to 35 µm. When thermally expandable microspheres having an average particle diameter of 50 µm or less are used, before the foaming of the thermally expandable microspheres (i.e., in a situation in which the heat-peelable layer needs to have a pressure-sensitive adhesive property), the thermally expandable microspheres hardly affect the heat-peelable layer surface, and hence there can be obtained a pressure-sensitive adhesive sheet having an excellent pressure-sensitive adhesive property with high adhesiveness to an adherend. The average particle diameter of the thermally expandable microspheres is preferably as large as possible within the above-mentioned ranges because the thermally expandable microspheres expand more when heated. When thermally expandable microspheres having an average particle diameter within the above-mentioned ranges are used, a pressure-sensitive adhesive sheet excellent in peelability can be obtained. The average particle diameter of the thermally expandable microspheres may be controlled on the basis of, for example, conditions for the polymerization of the thermally expandable microspheres (e.g., the rotation speed of a stirring blade during the polymerization, and a polymerization temperature). In addition, when commercially available thermally expandable microspheres are used, the average particle diameter may be controlled by classification treatment, such as mesh treatment, filter treatment, or centrifugal treatment. Herein, the average particle diameter may be measured by observing the thermally expandable microspheres to be used, or thermally expandable microspheres removed from the heat-peelable layer before heating, through use of an optical microscope or an electron microscope. In addition, the average particle diameter may be measured by a particle size distribution measurement method in a laser scattering method. More specifically, the average particle diameter may be measured using a particle size distribution measurement apparatus (e.g., a product manufactured under the product name "SALD-2000J" by Shimadzu Corporation) after the thermally expandable microspheres to be used have been dispersed in a predetermined solvent (e.g., water).

It is preferred that the thermally expandable microspheres each have such a moderate strength that rupture does not occur until a volume expansion ratio reaches preferably 5 times or more, more preferably 7 times or more, still more preferably 10 times or more. When such thermally expandable microspheres are used, the pressure-sensitive adhesive strength can be efficiently lowered through heat treatment.

The content of the thermally expandable microspheres in the heat-peelable layer may be appropriately set depending on, for example, a desired decreasing property of the pressure-sensitive adhesive strength. The content of the thermally expandable microspheres is preferably from 20 parts by weight to 210 parts by weight, more preferably from 30 parts by weight to 200 parts by weight, still more preferably from 50 parts by weight to 150 parts by weight with respect to 100 parts by weight of the base polymer. When the content falls within such ranges, there can be obtained a pressure-sensitive adhesive sheet that shows a satisfactory adhesive property during backgrinding, and that allows an adherend to be easily peeled therefrom when heated.

The content ratio of the thermally expandable microspheres in the heat-peelable layer is preferably from 5 wt% to 80 wt%, more preferably from 10 wt% to 70 wt%, still more preferably from 15 wt% to 65 wt% with respect to the weight of the heat-peelable layer. The content ratio of the thermally expandable microspheres may be calculated from the volume filling ratio (volume filling ratio at a temperature equal to or lower than the foaming starting temperature (e.g., at 23°C)) of the thermally expandable microspheres obtained by X-ray CT analysis, SEM analysis, or the like, the specific gravity of the thermally expandable microspheres, and the specific gravity of a region other than the thermally expandable microspheres. In one embodiment, the calculation may be performed on the basis of a rough estimate that the specific gravity of the thermally expandable microspheres is 1 and the specific gravity of the region other than the thermally expandable microspheres is 1, and the content ratio of the thermally expandable microspheres in this case falls within the above-mentioned ranges.

The content ratio of the thermally expandable microspheres in the heat-peelable layer is preferably from 5 vol% to 80 vol%, more preferably from 10 vol% to 70 vol%, still more preferably from 15 vol% to 65 vol% with respect to the volume of the heat-peelable layer. The volume-based content ratio corresponds to the volume filling ratio, and as described above, may be measured by X-ray CT analysis, SEM analysis, or the like. More specifically, the volume filling ratio may be measured by the following method.

### <Volume Filling Ratio Measurement Method>

i) The heat-peelable layer is fixed to a holder, and 1,601 successive transmission images thereof are taken by X-ray CT at from 0° to 180°. In the X-ray CT, measurement is performed with ZEISS, Xradia 520 Versa at a tube voltage of 40 kV, a tube current of 73 µA, and a pixel size of 0.3 µm/pixel.
ii) Reconstruction is performed on the basis of the resultant full transmission images to create tomographic images, and a three-dimensional reconstructed image (TIF stack image) and a reconstructed cross-sectional image (three-sided view) are created using analytical software ImageJ.
iii) The resultant three-dimensional reconstructed image (TIF stack image) is subjected to image processing to identify the thermally expandable microspheres. On the basis of the results of the identification, a volume filling ratio in a thickness direction, the volumes of individual foams, and the sphere-equivalent diameters thereof are calculated.

The thickness of the heat-peelable layer of each sample is measured by SEM cross-sectional observation, and the filling ratio is calculated using a value excluding cell portions as a total volume.

An inorganic foaming agent or an organic foaming agent may be used as the foaming agent. Examples of the inorganic foaming agent include ammonium carbonate, ammonium hydrogen carbonate, sodium hydrogen carbonate, ammonium nitrite, sodium boron hydroxide, and various azides. In addition, examples of the organic foaming agent include: a chlorofluoroalkane-based compound, such as trichloromonofluoromethane or dichloromonofluoromethane; an azo-based compound, such as azobisisobutyronitrile, azodicarbonamide, or barium azodicarboxylate; a hydrazine-based compound, such as p-toluenesulfonylhydrazide, diphenyl sulfone-3,3'-disulfonylhydrazide, 4,4'-oxybis(benzenesulfonylhydrazide), or allylbis(sulfonylhydrazide); a semicarbazide-based compound, such as p-toluylenesulfonylsemicarbazide or 4,4'-oxybis(benzenesulfonylsemicarbazide); a triazole-based compound, such as 5-morpholyl-1,2,3,4-thiatriazole; and an N-nitroso-based compound, such as N,N'-dinitrosopentamethylenetetramine or N,N'-dimethyl-N,N'-dinitrosoterephthalamide.

### C. Pressure-sensitive Adhesive Tape

In one embodiment, the pressure-sensitive adhesive tape includes a base material and a pressure-sensitive adhesive layer arranged on at least one side of the base material. The pressure-sensitive adhesive tape may further include any appropriate other layer, such as an elastic layer.

Examples of the base material include a resin sheet, a nonwoven fabric, paper, metal foil, a woven fabric, a rubber sheet, a foamed sheet, and laminates thereof (particularly a laminate containing a resin sheet). As a resin for forming the resin sheet, there are given, for example, polyethylene terephthalate (PET), polyethylene naphthalate (PEN), polybutylene terephthalate (PBT), polyethylene (PE), polypropylene (PP), an ethylene-propylene copolymer, an ethylene-vinyl acetate copolymer (EVA), polyamide (nylon), wholly aromatic polyamide (aramid), polyimide (PI), polyvinyl chloride (PVC), polyphenylene sulfide (PPS), a fluorine-based resin, and polyether ether ketone (PEEK). Examples of the non-woven fabric include: non-woven fabrics of natural fibers each having heat resistance, such as a non-woven fabric containing Manila hemp; and non-woven fabrics of synthetic resins, such as a non-woven fabric of a polypropylene resin, a non-woven fabric of a polyethylene resin, and a non-woven fabric of an ester-based resin. Examples of the metal foil include copper foil, stainless-steel foil, and aluminum foil. Examples of the paper include Japanese paper and kraft paper. The base material may be a single layer or a multilayer. When the base material is a multilayer, the configurations of its layers may be identical to or different from each other.

The thickness of the base material is preferably 1,000 µm or less, more preferably from 1 µm to 1,000 um, still more preferably from 1 µm to 500 um, particularly preferably from 3 µm to 300 µm, most preferably from 5 µm to 250 µm.

The base material may be subjected to surface treatment. Examples of the surface treatment include corona treatment, chromic acid treatment, ozone exposure, flame exposure, high-voltage electric shock exposure, ionizing radiation treatment, and coating treatment with an undercoating agent.

Examples of the organic coating material include materials described in Plastic Hard Coat Material II (CMC Publishing Co., Ltd., (2004)). A urethane-based polymer is preferably used, and polyurethane acrylate, polyester polyurethane, or a precursor thereof is more preferably used. This is because of the following reasons: any such material can be easily coated and applied onto the base material; and many kinds of the material can be industrially selected and are each available at low cost. The urethane-based polymer is, for example, a polymer formed of a reacted mixture of an isocyanate monomer and an alcoholic hydroxy group-containing monomer (e.g., a hydroxy group-containing acrylic compound or a hydroxy group-containing ester compound). The organic coating material may contain, as an optional additive, a chain extender, such as polyamine, an age resistor, an oxidation stabilizer, or the like. The thickness of an organic coating layer is not particularly limited, but is suitably, for example, from about 0.1 µm to about 10 µm, preferably from about 0.1 µm to about 5 µm, more preferably from about 0.5 µm to about 5 µm.

Any appropriate pressure-sensitive adhesive layer may be formed as the pressure-sensitive adhesive layer. As a pressure-sensitive adhesive for forming the pressure-sensitive adhesive layer, there are given, for example, a rubber-based pressure-sensitive adhesive, an acrylic pressure-sensitive adhesive, a vinyl alkyl ether-based pressure-sensitive adhesive, a silicone-based pressure-sensitive adhesive, a polyester-based pressure-sensitive adhesive, a polyamide-based pressure-sensitive adhesive, a urethane-based pressure-sensitive adhesive, a fluorine-based pressure-sensitive adhesive, and a styrene-diene block copolymer-based pressure-sensitive adhesive. The pressure-sensitive adhesive may have blended therein, for example, a known or commonly used additive, such as a plasticizer, a filler, a surfactant, an age resistor, or a tackifier.

In one embodiment, the pressure-sensitive adhesive layer has heat peelability. An example of the pressure-sensitive adhesive layer having heat peelability is a pressure-sensitive adhesive layer having a configuration similar to that of the heat-peelable layer described above.

The thickness of the pressure-sensitive adhesive layer is preferably 300 µm or less, more preferably from 1 µm to 300 µm, still more preferably from 5 µm to 100 µm.

### Examples

Now, the present invention is specifically described by way of Examples. However, the present invention is by no means limited to these Examples. Evaluation methods in Examples are as described below. In the following evaluations, a pressure-sensitive adhesive sheet obtained by peeling a separator was used. In addition, the terms "part (s)" and "%" in Examples are by weight unless otherwise stated.

### [Example 1]

### (Production of Laminate A (Support/Heat-peelable Layer))

100 Parts by weight of a maleic acid-modified styrene-ethylene-butylene-styrene block copolymer (a) (SEBS: styrene moiety/ethylene-butylene moiety (weight ratio)=30/70, acid value: 10 (mg-CH₃ONa/g), manufactured by Asahi Kasei Chemicals Corporation, product name: "Tuftec M1913"), 300 parts by weight of a terpene phenol-based tackifying resin (manufactured by Yasuhara Chemical Co., Ltd., product name: "YS POLYSTER T80"), 3 parts by weight of an epoxy-based cross-linking agent (manufactured by Mitsubishi Gas Chemical Company, product name: "TETRAD-C"), 150 parts by weight of thermally expandable microspheres (manufactured by Matsumoto Yushi-Seiyaku Co., Ltd., product name: "Matsumoto Microsphere F-50D", foaming starting temperature: 120°C, average particle diameter: 14 µm), 5 parts by weight of a phosphoric acid ester-based surfactant (manufactured by Toho Chemical Industry Co., Ltd., product name: "PHOSPHANOL RL210", chemical formula: C₂₂H₄₇O₅P, carbon number of alkyl group: 18, molecular weight: 422.57), and toluene serving as a solvent were mixed to prepare a resin composition (I). The resin composition (I) was applied onto a separator so as to have a thickness of 50 µm after drying, and was dried to form a heat-peelable layer. Further, a support was arranged on a heat pressing machine heated to 80°C, and the heat-peelable layer was heat-laminated to the support with bonding rolls of a laminator under the conditions of a pressure of 0.2 MPa and a speed of 0.5 m/min. Thus, a laminate A having the configuration "support/heat-peelable layer" was obtained.

### (Production of Laminate B (Workpiece/Pressure-sensitive Adhesive Tape))

100 Parts by weight of a maleic acid-modified styrene-ethylene-butylene-styrene block copolymer (b) (SEBS: styrene moiety/ethylene-butylene moiety (weight ratio)=30/70, acid value: 10 (mg-CH₃ONa/g), manufactured by Asahi Kasei Chemicals Corporation, product name: "Tuftec M1913"), 50 parts by weight of a terpene phenol-based tackifying resin (manufactured by Yasuhara Chemical Co., Ltd., product name: "YS POLYSTER T80"), 3 parts by weight of an epoxy-based cross-linking agent (manufactured by Mitsubishi Gas Chemical Company, product name: "TETRAD-C"), 3 parts by weight of a phosphoric acid ester-based surfactant (manufactured by Toho Chemical Industry Co., Ltd., product name: "PHOSPHANOL RL210", carbon number of alkyl group: 18, molecular weight: 422.57), and toluene serving as a solvent were mixed to prepare a resin composition (II). The resin composition (II) was applied onto a PET base material (thickness: 50 µm) so as to have a thickness of 30 µm after drying, and was dried to form a pressure-sensitive adhesive layer. Thus, a pressure-sensitive adhesive tape having the configuration "pressure-sensitive adhesive layer/base material" was obtained.

A sapphire wafer having a thickness of 900 µm and a size of 10.2 cm (4 inches) was arranged on a heater heated to 80°C, and then the obtained pressure-sensitive adhesive tape was heat-laminated to the sapphire wafer with bonding rolls of a laminator under the conditions of a pressure of 0.2 MPa and a speed of 0.5 m/min. Thus, a laminate B having the configuration "workpiece (sapphire wafer)/pressure-sensitive adhesive tape" was obtained.

### (Bonding of Laminate A and Laminate B)

The laminate A and the laminate B were laminated so that the heat-peelable layer of the laminate A and the base material of the pressure-sensitive adhesive tape of the laminate B were opposed to each other, and the whole was subjected to compression bonding with a heat pressing machine heated to 90°C at a pressure of 60 kN for 5 minutes to fix the workpiece (sapphire wafer) onto the support via a laminate having the configuration "heat-peelable layer/base material/pressure-sensitive adhesive layer."

### (Processing of Workpiece (Sapphire Wafer))

The sapphire wafer was ground using a grinder apparatus DFG8540 manufactured by DISCO Corporation until the wafer thickness became 120 µm.

### (Separation between Heat-peelable Layer/Pressure-sensitive Adhesive Tape)

After the processing, the workpiece (sapphire wafer) fixed onto the support via the laminate having the configuration "heat-peelable layer/base material/pressure-sensitive adhesive layer" was put into an oven at 130°C and heated for 5 minutes to separate the laminate B (workpiece/pressure-sensitive adhesive tape) from the laminate A (support/heat-peelable layer).

### (Peeling of Pressure-sensitive Adhesive Tape)

The pressure-sensitive adhesive tape was peeled from the laminate B obtained by being separated as described above. The peeling of the pressure-sensitive adhesive tape was performed at a peel angle of 180° after the pressure-sensitive adhesive tape had been arranged on a heater heated to 80°C with the workpiece (sapphire wafer) being on the lower side.

### (Evaluation)

In the above-mentioned operations, damage to the sapphire wafer at the time of the processing of the workpiece, damage to the sapphire wafer at the time of the separation of the laminate B (workpiece/pressure-sensitive adhesive tape), and damage to the sapphire wafer at the time of the peeling of the pressure-sensitive adhesive tape did not occur.

The shear adhesive strength of the heat-peelable layer for SUS304BA at 25°C was measured by the following method, and the shear adhesive strength was found to be 650 N/cm².

### <Measurement Method for Shear Adhesive Strength>

The peelable layer (size: 20 mm×20 mm) was bonded and fixed to SUS304BA. Another SUS304BA plate was caused to sandwich the peelable layer, and the SUS304BA plates were compression-bonded to each other with a heat pressing machine under the bonding conditions of 80°C and 0.3 MPa for 1 minute to produce an evaluation sample.

With use of the evaluation sample, under an ambient temperature of 25°C, a product manufactured under the product name "Shimadzu Autograph AG-120kN" by Shimadzu Corporation was used to apply an external force in a horizontal direction to the chip at a tensile rate of 50 mm/min, and the maximum breaking load was read from the thus obtained load-displacement curve and was adopted as a shear adhesive strength under an ambient temperature of 25°C.

### [Example 2]

### (Production of Laminate A (Support/Heat-peelable Layer))

A laminate A was obtained in the same manner as in Example 1.

### (Production of Laminate B (Workpiece/Pressure-sensitive Adhesive Tape))

100 Parts by weight of a maleic acid-modified styrene-ethylene-butylene-styrene block copolymer (b) (SEBS: styrene moiety/ethylene-butylene moiety (weight ratio)=30/70, acid value: 10 (mg-CH₃ONa/g), manufactured by Asahi Kasei Chemicals Corporation, product name: "Tuftec M1913"), 50 parts by weight of a terpene phenol-based tackifying resin (manufactured by Yasuhara Chemical Co., Ltd., product name: "YS POLYSTER T80"), 3 parts by weight of an epoxy-based cross-linking agent (manufactured by Mitsubishi Gas Chemical Company, product name: "TETRAD-C"), 150 parts by weight of thermally expandable microspheres (manufactured by Matsumoto Yushi-Seiyaku Co., Ltd., product name: "Matsumoto Microsphere FN-100SS", foaming starting temperature: 170°C, average particle diameter: 14 µm), 3 parts by weight of a phosphoric acid ester-based surfactant (manufactured by Toho Chemical Industry Co., Ltd., product name: "PHOSPHANOL RL210", carbon number of alkyl group: 18, molecular weight: 422.57), and toluene serving as a solvent were mixed to prepare a resin composition (II'). The resin composition (II') was applied onto a PET base material (thickness: 50 µm) so as to have a thickness of 30 µm after drying, and was dried to form a pressure-sensitive adhesive layer. Thus, a pressure-sensitive adhesive tape having the configuration "pressure-sensitive adhesive layer/base material" was obtained.

A sapphire wafer having a thickness of 900 µm and a size of 10.2 cm (4 inches) was arranged on a heater heated to 80°C, and then the obtained pressure-sensitive adhesive tape was heat-laminated to the sapphire wafer with bonding rolls of a laminator under the conditions of a pressure of 0.2 MPa and a speed of 0.5 m/min. Thus, a laminate B having the configuration "workpiece (sapphire wafer)/pressure-sensitive adhesive tape" was obtained.

### (Bonding of Laminate A and Laminate B)

The laminate A and the laminate B were bonded to each other in the same manner as in Example 1 to fix the workpiece (sapphire wafer) onto the support via a laminate having the configuration "heat-peelable layer/base material/pressure-sensitive adhesive layer."

### (Processing of Workpiece (Sapphire Wafer))

The sapphire wafer was ground in the same manner as in Example 1.

### (Separation between Heat-peelable Layer/Pressure-sensitive Adhesive Tape)

The laminate B (workpiece/pressure-sensitive adhesive tape) was separated from the laminate A (support/heat-peelable layer) in the same manner as in Example 1.

### (Peeling of Pressure-sensitive Adhesive Tape)

The pressure-sensitive adhesive tape side of the laminate B obtained by being separated as described above was heated with a heater at 190°C for 5 minutes to peel off the pressure-sensitive adhesive tape.

### (Evaluation)

In the above-mentioned operations, damage to the sapphire wafer at the time of the processing of the workpiece, damage to the sapphire wafer at the time of the separation of the laminate B (workpiece/pressure-sensitive adhesive tape), and damage to the sapphire wafer at the time of the peeling of the pressure-sensitive adhesive tape did not occur.

### [Comparative Example 1]

The same sapphire wafer as the sapphire wafer used in Example 1 was fixed onto a support via a solid wax (manufactured by Nikka Seiko Co., Ltd., product name: "SHIFTWAX 582W"). The fixation was performed by arranging the sapphire wafer on the solid wax, followed by compression bonding with a heat pressing machine heated to 110°C at a pressure of 10 kN for 5 minutes.

Then, the sapphire wafer was ground in the same manner as in Example 1.

Then, the solid wax was melted by heating at 120°C for 5 minutes with a heater to separate the sapphire wafer from the support.

In the above-mentioned operations, damage to the sapphire wafer was recognized during the separation of the sapphire wafer.

### [Comparative Example 2]

The same sapphire wafer as the sapphire wafer used in Example 1 was fixed onto a support via a UV-curable acrylic adhesive (manufactured by 3M Company, product name: "LC-5200"). The fixation was performed by arranging the sapphire wafer on the support via the UV-curable acrylic adhesive, and then subjecting the resultant to compression bonding under ordinary temperature and at a pressure of 10 kN for 5 minutes, followed by irradiation with UV light to cure the UV-curable acrylic adhesive.

Then, the sapphire wafer was ground in the same manner as in Example 1.

Then, the adhesion layer was irradiated with a UV laser to make the adhesion layer brittle, to thereby separate the sapphire wafer from the support.

In the above-mentioned operations, damage to the sapphire wafer was recognized during the separation of the sapphire wafer.

### Reference Signs List

- **100**: support
- **200**: workpiece
- **300**: heat-peelable layer
- **400**: pressure-sensitive adhesive tape

## Claims

1. A method of manufacturing an electronic part, which includes processing a workpiece (200) fixed onto a support (100),
the method comprising:
fixing the workpiece (200) by arranging at least one heat-peelable layer (300) between the support (100) and the workpiece (200);
processing a surface of the fixed workpiece (200) on an opposite side to the heat-peelable layer (300); and
separating the workpiece (200) from the support (100) by heating the heat-peelable layer (300) after the processing,
wherein the fixing the workpiece (200) comprises:
arranging a pressure-sensitive adhesive tape (400) between the support (100) and the workpiece (200);
forming a laminate A including the support (100) and the heat-peelable layer (300);
forming a laminate B including the workpiece (200) and the pressure-sensitive adhesive tape (400); and
bonding the heat-peelable layer (300) of the laminate A and the pressure-sensitive adhesive tape (400) of the laminate B to each other.

2. The method of manufacturing an electronic part according to claim 1, wherein the fixing the workpiece (200) comprises arranging the pressure-sensitive adhesive tape (400) between the heat-peelable layer (300) and the workpiece (200).

3. The method of manufacturing an electronic part according to claim 2, wherein the pressure-sensitive adhesive tape (400) is in a state of being bonded to the workpiece (200) during the separating the workpiece (200).

4. The method of manufacturing an electronic part according to any one of claims 1 to 3, wherein the bonding of the laminate A and the laminate B is performed by thermocompression bonding at from 80°C to 150°C.

5. The method of manufacturing an electronic part according to any one of claims 1 to 4, wherein a heating temperature in the separating the workpiece (200) from the support (100) is from 90°C to 300°C.

6. The method of manufacturing an electronic part according to any one of claims 1 to 5, wherein the heat-peelable layer (300) contains thermally expandable microspheres.

## Patentansprüche

1. Verfahren zur Herstellung eines elektronischen Bauteils, das die Bearbeitung eines auf einem Träger (100) befestigten Werkstücks (200) umfasst,
wobei das Verfahren umfasst:
Befestigen des Werkstücks (200) durch Anordnen mindestens einer wärmeabziehbaren Schicht (300) zwischen dem Träger (100) und dem Werkstück (200);
Bearbeiten einer Oberfläche des befestigten Werkstücks (200) auf einer gegenüberliegenden Seite zu der wärmeabziehbaren Schicht (300); und
Trennen des Werkstücks (200) vom Träger (100) durch Erwärmen der wärmeabziehbaren Schicht (300) nach dem Bearbeiten,
wobei das Befestigen des Werkstücks (200) umfasst:
Anordnen eines druckempfindlichen Klebebands (400) zwischen dem Träger (100) und dem Werkstück (200);
Bilden eines Laminats A, das den Träger (100) und die wärmeabziehbare Schicht (300) enthält;
Bilden eines Laminats B, das das Werkstück (200) und das druckempfindliche Klebeband (400) enthält; und
Verbinden der wärmeabziehbaren Schicht (300) des Laminats A und des druckempfindlichen Klebebands (400) des Laminats B miteinander.

2. Verfahren zur Herstellung eines elektronischen Bauteils nach Anspruch 1, wobei das Befestigen des Werkstücks (200) das Anordnen des druckempfindlichen Klebebands (400) zwischen der wärmeabziehbaren Schicht (300) und dem Werkstück (200) umfasst.

3. Verfahren zur Herstellung eines elektronischen Bauteils nach Anspruch 2, wobei das druckempfindliche Klebeband (400) während des Trennens des Werkstücks (200) mit dem Werkstück (200) in einem Zustand des Verbundenseins ist ist.

4. Verfahren zur Herstellung eines elektronischen Bauteils nach einem der Ansprüche 1 bis 3, wobei das Verbinden des Laminats A und des Laminats B durch Thermokompressionsverbinden bei von 80°C bis 150°C durchgeführt wird.

5. Verfahren zur Herstellung eines elektronischen Bauteils nach einem der Ansprüche 1 bis 4, wobei die Erwärmungstemperatur beim Trennen des Werkstücks (200) vom Träger (100) von 90°C bis 300°C beträgt.

6. Verfahren zur Herstellung eines elektronischen Bauteils nach einem der Ansprüche 1 bis 5, wobei die wärmeabziehbare Schicht (300) thermisch ausdehnbare Mikrokugeln enthält.

## Revendications

1. Procédé de fabrication d'une pièce électronique, qui inclut usiner une pièce à usiner (200) fixée sur un support (100),
le procédé comprenant :
fixer la pièce à usiner (200) en agençant au moins une couche pouvant être pelée thermiquement (300) entre le support (100) et la pièce à usiner (200) ;
usiner une surface de la pièce à usiner fixée (200) sur un côté opposé à la couche pouvant être pelée thermiquement (300) ; et
séparer la pièce à usiner (200) du support (100) en chauffant la couche pouvant être pelée thermiquement (300) après l'usinage,
dans lequel la fixation de la pièce à usiner (200) comprend :
agencer un ruban adhésif sensible à la pression (400) entre le support (100) et la pièce à usiner (200) ;
former un stratifié A incluant le support (100) et la couche pouvant être pelée thermiquement (300) ;
former un stratifié B incluant la pièce à usiner (200) et le ruban adhésif sensible à la pression (400) ; et
assembler la couche pouvant être pelée thermiquement (300) du stratifié A et le ruban adhésif sensible à la pression (400) du stratifié B l'un à l'autre.

2. Procédé de fabrication d'une pièce électronique selon la revendication 1, dans lequel la fixation de la pièce à usiner (200) comprend agencer le ruban adhésif sensible à la pression (400) entre la couche pouvant être pelée thermiquement (300) et la pièce à usiner (200).

3. Procédé de fabrication d'une pièce électronique selon la revendication 2, dans lequel le ruban adhésif sensible à la pression (400) est dans un état d'être assemblé à la pièce à usiner (200) au cours de la séparation de la pièce à usiner (200).

4. Procédé de fabrication d'une pièce électronique selon l'une quelconque des revendications 1 à 3, dans lequel l'assemblage du stratifié A et du stratifié B est réalisé par assemblage par thermocompression à une température allant de 80 °C à 150 °C.

5. Procédé de fabrication d'une pièce électronique selon l'une quelconque des revendications 1 à 4, dans lequel une température de chauffage dans la séparation de la pièce à usiner (200) du support (100) va de 90 °C à 300 °C.

6. Procédé de fabrication d'une pièce électronique selon l'une quelconque des revendications 1 à 5, dans lequel la couche pouvant être pelée thermiquement (300) contient des microsphères pouvant être dilatées thermiquement.
